Europäisches Patentamt

European Patent Office

Office européen des brevets

(11) Publication number: 0 401 994
A2

# EUROPEAN PATENT APPLICATION

(21) Application number: **90305410.4**

(22) Date of filing: **18.05.90**

(51) Int. Cl.5: **G06F 11/10**

(30) Priority: **05.06.89 US 361456**

(43) Date of publication of application:
**12.12.90 Bulletin 90/50**

(84) Designated Contracting States:
**DE FR GB**

(71) Applicant: **Hewlett-Packard Company**
**Mail Stop 20 B-O, 3000 Hanover Street**
**Palo Alto, California 94304(US)**

(72) Inventor: **La Fetra, Ross V.**
**202 Calvert Drive, No. 129**
**Cupertino, California 95014(US)**

(74) Representative: **Colgan, Stephen James et al**
**CARPMAELS & RANSFORD 43 Bloomsbury**
**Square**
**London WC1A 2RA(GB)**

(54) Method of implementing error corrected memory.

(57) A method of storing and retrieving a word (60) of digital information in a computer random access memory (124, 126) which includes generating a plurality of subwords (68, 69) from the word, storing the subwords in memory, reading the subwords from memory, and reconstructing the word from the subwords. Each generated subword (68, 69) contains a segment of digital information from the word (66, 67) and an error detection value capable of detecting an error in the subword. The generated subwords (68, 69) contain enough digital information to reconstruct the word at least once. Each generated subword is then stored in at least one location in memory (78, 79). A plurality of subwords containing enough digital information to reconstruct the word (60) are read from memory. The subwords so read are checked for errors. If a subword is found to contain an error, at least one replacement subword may be read from memory. The word of digital information is then reconstructed from the read subwords not containing an error.

FIG._4.

EP 0 401 994 A2

# A METHOD OF IMPLEMENTING ERROR CORRECTED MEMORY

## BACKGROUND OF THE INVENTION

This invention relates generally to the storage and retrieval of digital information in memory, and more particularly, to preserving the validity of digital information stored in memory.

Digital information may be stored in a multitude of magnetic, optical, or other types of storage devices. Digital information is generally organized into words which are pieces of information that are handled in blocks by a computer processor. A word is generally a data item, an address, an instruction, or other unitary pieces of information represented by multiple binary bits.

In order to preserve the validity of digital information, each word generally contains an error detection value such as a parity bit or bits. For example, a single parity bit may be included at the end of the word which indicates whether the word has an odd or even number of ones. As a result, a single error in any bit, including the parity bit, would result in the word having incorrect parity. However, if there are two errors, then a single parity bit will not be useful in detecting the errors. To do double error detection, more parity bits are needed.

The error detection value may also be used as a correction key to correct the word in the case of an error. However, this requires more bits than what is required for detecting an error.

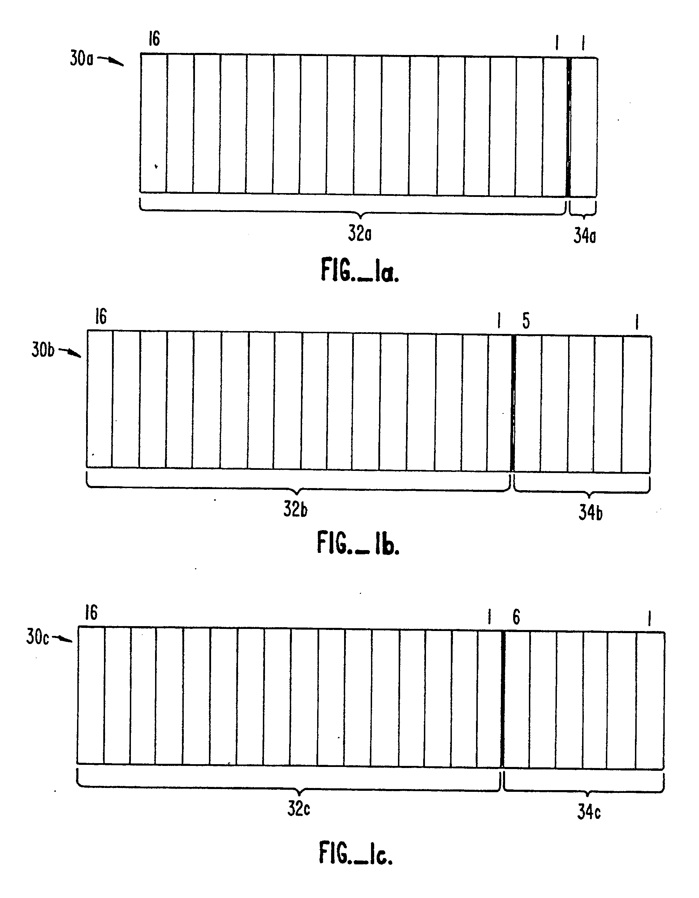

Figs. 1a-c show examples of words having 16 bits of digital information in combination with an error correction value. Fig. 1a shows a word 30a having a 16 bit word segment 32a containing 16 bits of digital information, and a parity bit 34a. This example is only capable of detecting a single bit error. Fig. 1b shows a word 30b having a 16 bit word segment 32b and a five parity bit error correction value 34b. This example is capable of detecting and correcting all single bit errors plus detecting some double bit errors. Fig. 1c shows a word 30c having a 16 bit word segment 32c and a six parity bit error correction value 34c. This example is capable of detecting and correcting all single bit errors plus detecting all double bit errors.

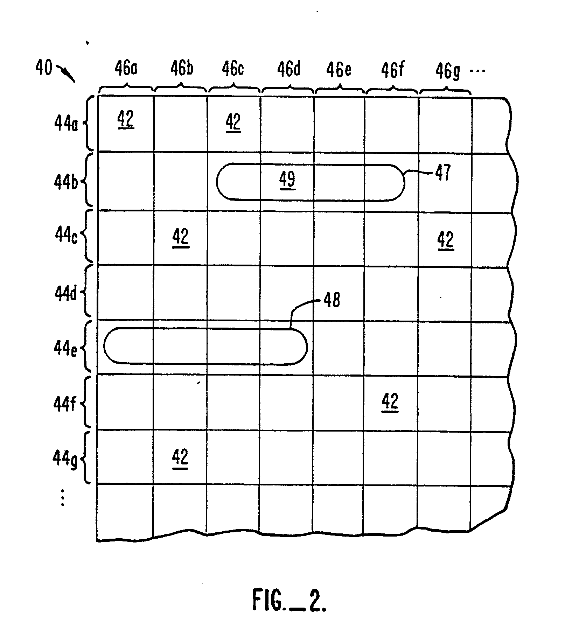

Errors can be caused by a variety of storage device failures. Fig. 2 shows a typical random access memory (RAM) bank 40. A computer may have multiple RAM banks (e.g., multiple RAM semiconductor chips). RAM bank 40 has a grid of memory cells 42 organized into word lines 44a-g and bit lines 46a-g. Each memory cell generally contains one bit of data. For example, 4 bit words can be stored in locations 47 and 48.

The most common device error is a cell error. A cell error is a failure in one bit in a specific memory location. For example, if cell at location 49 fails, then that cell would give a random value dependent on the type of cell error. Furthermore, if the bit stored at location 49 previously had a different value than the error value, then the word stored at location 47 would have a single bit error. If bit line 46c fails, then the words stored at locations 47 and 48 could each have a single bit error. In addition, if word line 44e fails, then the word stored at location 48 could have up to 4 errors. Furthermore, if RAM bank 40 fails, then both words could have up to 4 errors. As a result, the inclusion of an error correction value in a word is not sufficient to fully protect that word from some types of storage device errors or failures.

One method used to preserve the validity of digital information is word duplication. For example, a word may be stored in a primary location such as RAM while a second copy of the word may be stored in a backup mass storage medium such as magnetic tape. This scheme protects the word from cell, bit line, word line, or RAM bank failures. However, this scheme is generally used for the correction of large numbers of words when a device or program fails or enters some other error state. What is needed is a more efficient technique for correcting bit errors in a random access memory.

## SUMMARY OF THE INVENTION

According to the invention, a method of storing and retrieving a word of digital information in a computer random access memory includes generating a plurality of subwords from the word, storing the subwords in memory, reading the subwords from memory, and reconstructing the word from the subwords. Each generated subword contains a segment of digital information from the word and an error detection value capable of detecting an error in the subword. The generated subwords contain enough digital information to reconstruct the word at least once. Each generated subword is then stored in at least one location in memory. A plurality of subwords containing enough digital information to reconstruct the word are read from memory. The subwords so read are checked for errors. If a subword is found to contain an error, at least one replacement subword may be read from memory. The word of digital information is then reconstructed from the read subwords not containing an error.

This invention provides the ability to reconstruct a data word from less than the total number of subwords generated and stored in memory. As a result, the process of storing and retrieving a word of information is less likely to suffer fatal errors due to various types of storage device errors and failures such as cell error, bit line error, word line error and RAM bank error. This is particularly true where the subwords are stored in separate storage devices.

A further understanding of the nature and advantages of the present invention can be realized by reference to the remaining portions of the specification and the attached drawings.

## BRIEF DESCRIPTION OF THE DRAWINGS

Figs. 1a, 1b and 1c are diagrams of words containing parity bits for error detection or correction;

Fig. 2 is a diagram of a prior art RAM bank;

Figs. 3a and 3b are diagrams showing preferred methods for storing words in memory; and

Fig. 4 is a diagram of a preferred apparatus for retrieving words from memory.

## DESCRIPTION OF SPECIFIC EMBODIMENTS

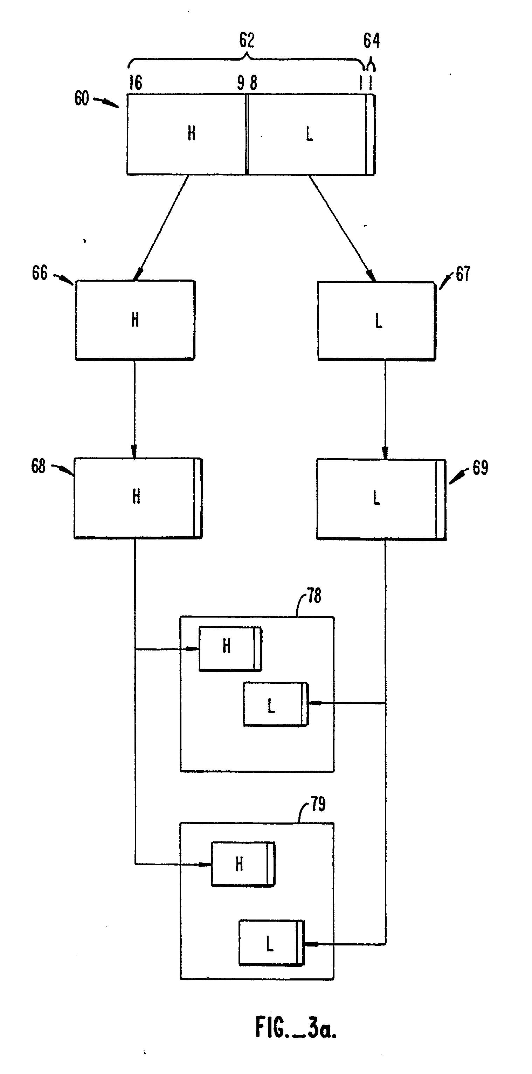

Fig. 3a is a diagram showing a first preferred for storing a word in memory. A word 60 is shown having a 16 bit word segment 62 and an error detection value segment 64 (e.g., a parity bit). Word segment 62 has a high order 8 bits and a low order 8 bits. In a first step, the word segment is divided into two 8 bit subword segments 66 and 67. Subword segment 66 contains the higher order bits of word segment 62, whereas subword segment 67 contains the lower order bits of word segment 62. In a second step, an error detection value, preferably a parity bit, is calculated for and appended to each subword segment, thereby providing subwords 68 and 69. Each subword is then stored in two separate storage devices 78 and 79, such as two separate RAM banks of a computer memory. As a result of this storage method, the word can be easily reconstructed if any subword is in error or even if both subwords in a storage device are in error.

Alternative methods may be used and still accomplish the same results as the first method. For example, words having segments and error correction values with more or fewer bits may be used, depending on the level of error correction desired. The word segment may be divided into more than two subword segments, thereby creating more than two subwords. The subword segments may have different lengths and may contain duplication of all or part of other subword segments. The subwords may be stored in the same storage device, but this increases the chance of an unrecoverable error due to storage device failure. Each subword may contain an error detection value capable of correcting single or multi-bit subword errors. The subwords may be stored in more than two locations. Furthermore, duplicate subwords may be generated first and then each subword stored only once in memory.

Each of the above described alternative methods may increase or decrease the reliability of the stored digital information. Furthermore, the above described alternative embodiments may also increase or decrease the efficiency of the storage and retrieval methods.

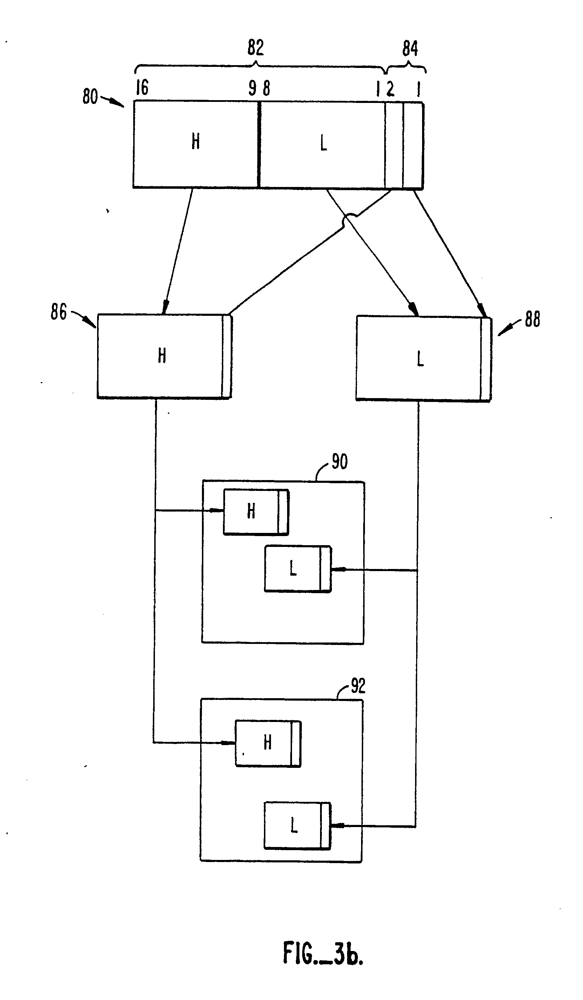

Fig. 3b is a diagram showing a second preferred method for storing a word in memory. A word 80 is shown having a 16 bit word segment 82 and a 2 bit error detection value 84. Word 80 has the property that the upper bit of the error detection value relates only to the upper 8 digits of the 16 bit word segment and the lower bit of the error detection value relates only to the lower 8 digits of the 16 bit word segment. As a result, subwords 86 and 88 are generated by simply combining the relating digits from the word segment and error detection value. The subwords are then stored in two (or more) separate storage devices 90 and 92, preferably separate RAM banks.

This storage method achieves the same effect as the storage method shown in Fig. 3a. However, this storage method is faster if the word has the desired properties. The alternative embodiments described above may also apply to this method. For example, the error correction value could have more bits for each half of a word segment.

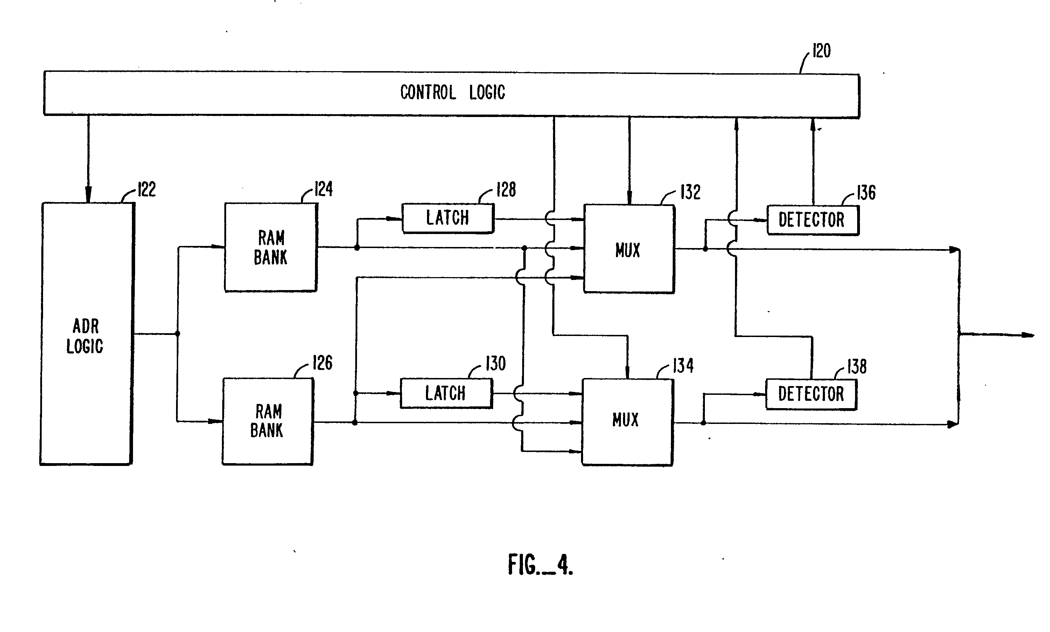

Fig. 4 is a diagram of an apparatus useful for illustrating a technique for retrieving a word stored in memory as described above in conjunction with in Figs. 3a and 3b. Control logic 120 causes address logic 122 to simultaneously address in parallel a first copy of the upper subword from a first storage device 124 and a first copy of the lower subword from a second storage device 126 (e.g., RAM banks). Control logic 120 then causes the latches 128 and 130 to latch the subwords and multiplexers 132 and 134 to combine the subwords into a word. Error detectors 136 and 138 are then instructed by the control logic to determine whether either of the subwords contains an error.

If error detectors 136 and 138 do not detect an error, then the process is complete. If an error is detected such that the multiplexed word is not correct, then control logic 120 causes address logic to address a second copy of the upper subword from RAM bank 126 and a second copy of the lower subword from RAM bank 124. Multiplexers 132 and 134 then select the second copy of the subword or subwords in error. Error detectors 136 and 138 again check each new subword and determine whether an error exists. If no error exists, then the process is complete. If one error detector continues to detect an error, then an error signal is generated by the control logic.

Alternative methods may be used to retrieve a word stored in memory as subwords. For example, more or fewer latches, multiplexers, and error detectors may be used, thereby retrieving the word in a more parallel or serial manner. The error detectors may search for errors in the subwords prior to their being multiplexed into words. Other modifications may be made to the method for adjusting to alternative methods of storing words as subwords.

The invention has now been described with reference to specific embodiments. Other embodiments will be apparent to those of ordinary skill in the art. It is therefore not intended that this invention be limited, except as defined in the appended claims.

## Claims

1. A method of storing a word (60) of digital information in a memory means (78, 79), comprising the steps of:

   a. generating a plurality of subwords (68, 69), each subword having a segment of digital information from the word (66, 67) and an error detection value suitable for detecting an error in the subword, such that the word (60) can be reconstructed from the plurality of the subwords; and

   b. storing each of the subwords in a plurality of locations in the memory means (78, 79).

2. The method of claim 1 wherein each subword is stored in a plurality of storage devices (124, 126) comprising the memory means.

3. The method of claim 1 wherein each error detection value is suitable for correcting at least one error in the subword (68, 69).

4. The method of claim 1 wherein the error detection values are obtained from the word (80).

5. The method of claim 1 wherein the error detection values are calculated from the subword segments (66, 67).

6. A method of storing a word (60) of digital information in a memory means (78, 79), comprising the steps of:

   a. generating a first plurality of subwords (78), each of said subwords having a segment of digital information from the word (60) and an error detection value suitable for detecting an error in the subword such that the digital information in the word (60) can be reconstructed from the first plurality of subwords (78);

   b. generating a second plurality of subwords (79), each of said subwords having a segment of digital information from the word (60) and an error detection value suitable for detecting an error in the subword, the digital information in each segment of the first and second plurality being duplicated at least once among other subwords such that the digital information in the word (60) can be reconstructed from the first and second plurality of subwords (79); and

   c. storing the subwords in the memory means (78, 79).

7. The method of claim 6 wherein each subword is stored in a separate storage device (124, 126).

8. The method of claim 6 wherein the subword error detection values are obtained from an error detection value contained in the word (80).

9. The method of claim 6 wherein the subword error detection values are calculated from the subword segments (66, 67).

10. A method of retrieving a word (60) of digital information from a memory means, the word being stored as a first plurality of subwords (78, 79), each subword being stored in a second plurality of locations in memory (124, 126), each subword containing an error detection value suitable for detecting at least one error in the subword; comprising the steps of:

   a. reading a first one of each of the first plurality of subwords (78);

   b. determining whether any of the read subwords contains an error (136, 138);

   c. reading at least one replacement subword for each of the subwords determined to contain an error (79); and

   d. multiplexing (132, 134) the read subwords into the word.

11. The method of claim 10 further comprising the step of latching (128, 130) a first one of each of the first plurality of subwords that have been read.

12. The method of claim 10 wherein a plurality of multiplexers (132, 134) are used to multiplex the read subwords into a plurality of words.

13. The method of claim 10 further comprising the step of correcting any of the subwords (68, 69) containing errors that can be corrected.

14. A method of retrieving a word (60) of digital information from a memory means, the word being stored in the memory means as a plurality of subwords (78, 79), the digital information in each subword being duplicated at least once among other subwords, each subword containing an error detection value suitable for detecting at least one error in the subword, comprising the steps of:

a. reading a second plurality of subwords sufficient to reconstruct the word (79);

b. determining whether each of the read subwords contains an error (136, 138);

c. reading at least one subword having the digital information contained in subwords determined to contain an error (79); and

d. multiplexing (132, 134) the read subwords into a word.

15. The method of claim 14 further comprising the step of latching (128, 130) the read subwords.

16. The method of claim 14 wherein a plurality of multiplexers (132, 134) are used to multiplex the read subwords into a plurality of words.

17. The method of claim 14 further comprising the step of correcting any of the subwords (68, 69) containing errors that can be corrected.

18. A digital computer when programmed to operate according to the method as claimed in any of claims 1 to 17.

16

30a →

32a

34a

FIG._Ia.

16

30b →

32b

34b

FIG._Ib.

16

30c →

6

32c

34c

FIG._Ic.

FIG._2.

FIG._3a.

FIG._3b.

FIG._4.